# EUROPEAN PATENT APPLICATION

(11) **EP 1 327 988 A1**
(43) Date of publication of application: **16.07.2003**
(21) Application number: 02000673.0
(22) Date of filing: 11.01.2002
(51) Int. Cl.: G11B 27/10, G11C 7/16, G11B 19/02, G11B 27/32, G11B 27/34, G11B 33/10

(54) **Retrieval method and an apparatus for a multimedia database**

(71) Applicant: Thomson Licensing S.A., 92648 Boulogne Cedex (FR)
(72) Inventor: Tsang, Wing Hon, North Point (CN); Lee, Young Jae, Taipo, N.T., Hong Hong (CN)
(74) Representative: Rossmanith, Manfred, Dr.

(57) **Abstract**

A method for retrieving data files stored on a storage medium, e.g. a disk, is provided. The data files are associated with a plurality of attributes and an address. The attributes and the address of all stored data files are listed in an input table being stored as well on the disk. The method comprises the steps of selecting a first attribute among the plurality of associated attributes; generating a first output table containing only those entries of the input table corresponding to the selected first attribute; selecting a second attribute among the plurality of the associated attributes, the second attribute being different from the first attribute; and generating a second output table containing only those entries of the first output table corresponding to the selected second attribute. In addition an apparatus for sound reproduction is suggested. The apparatus comprises a memory, in which files of digital audio data are stored, a decoder for converting the stored audio data into analog sound signals, and circuitry for driving a loudspeaker. The memory contains data representing attributes of the stored audio files. A processor creates a table of audio files corresponding to an attribute selection of a user. Finally, the apparatus is equipped with a display for displaying the table.

## Description

The present invention is related to a method and an apparatus for a multimedia database. According to a first aspect, the invention is related to a method for creating attribute-driven selection tables for different kinds of sorting tables. According to a second aspect, the invention is related to an apparatus for applying the inventive method onto a physical storage medium like a CD-ROM.

With the increase of Internet usage as a source of audio data, data transfer operations between a personal computer and a recording device take on a more important role than ever. For example, users access the Internet via a personal computer or web devices available on the market and "browse the Web" by "surfing" for audio information. It may be possible for these users to transfer (download) audio information on recording media, e.g. minidisks, CD-ROMS, flash memory cards or a hard disk for subsequent reproduction. A very frequent type of audio files is MP3 files. The technical problem described in the following is not limited to MP3 files and is applicable to any type of audio files. However, for the sake of simplicity the description refers to MP3 files only.

A user may download a music file according to his current interest for a particular music style, for one or more specific artists or groups or according to hit lists. The downloaded music files are then finally stored e.g. on a CD-ROM which then may contain 150 or even more MP3 files. Usually the downloaded files are at first stored on the hard disk of a personal computer giving the opportunity to perform some kind of presorting offline before the CD-ROM is engraved.

It is known to utilize data according to the OSTA TOC (Optical Storage Technology Association Table of Content) to store characteristic data like ordinal number, title, artist and others. This data allows to create a play list. The play list structure contains a play list name, description and a list of tracks. The tracks in the list are played in a consecutive order. The OSTA TOC also allows to create a track list. The track list structure is equivalent to the play list structure but instead of indices it contains only track entry structures. It is placed in a separate file allowing discarding the "table of contents" information read previously. Discarding the "table of contents" is advantageous for devices equipped with small size memory.

However, even by utilizing the play list or the track list it is difficult for a user to navigate through all the entries in the play list.

The big amount of information now available to users, makes it desirable to have an effective means for the user to navigate this information using different sorting sequences.

Although it is possible to create a play list for each selection sequence, the number of lists will be huge. For example, if there are seven sortable attributes (title, artist, album, author, genre, track, and year) the number of multi-sort play list will be 7!, which equals 5040. Such a large number of lists requires a lot of disc storage space and enhances servo response time for the CD mechanism. Both effects are undesirable and can be avoided by two different approaches.

Firstly, it is possible to limit the number of levels to be sorted (e.g. only 2 levels will result in 7x6 = 42 lists). Secondly, only a few predefined sorting sequences can be allowed.

Although these approaches are suitable to reduce the required disk storage space, they have a negative impact on the user convenience. In general, a user does not always want to sort by some predefined sequences. Furthermore, depending on the contents of the items, the meaningfulness of some sorting sequences might be limited. For example, the sequence "Year>Artist>Album>Track" might have only one entry for the first 2 attributes, making it quite useless.

It is also possible to create tables of attributes at runtime, based on concepts from database management. However, the processing power and memory required could be quite high.

The OSTA TOC provides a mechanism for storing information of all songs on a CD. However, it does not provide an effective means of storing information for multi-sort. It is noted by those skilled in the art that the OSTA play list and track list are no suitable candidates for this purpose.

It is therefore desirable to provide a method for creating attribute-driven selection tables for different kinds of sorting tables.

According to a first aspect, the present invention proposes the use of cascaded and pre-sorted tables of attributes to implement an attribute-driven selection menu. The invention is based on an approach balancing the requirements for memory and processing power.

An example for a balanced approach would be to generate pre-sorted attribute tables offline. The device would simply read in these tables and generate the user interface without any sorting done at runtime. All sorting orders can be generated using only seven sets of tables, as it will be described in the detailed description of the invention.

According to a second aspect, the present invention proposes an apparatus suitable to apply the method according to the first aspect of the invention.

The inventive method is scalable in terms of resource requirements, i.e. on the level of the apparatus the necessary memory can be traded off for speed and/or the number of features.

Depending on the available hardware platform the generation of the pre-sorted tables is performed either online or offline. Therefore, for the inventive apparatus optical-, hard disk drive and flash-based memory are equally useful.

In the drawing the inventive method is illustrated by means of exemplary tables. In the drawing
Fig. 1 shows an MP3 player and an associated remote control,
Fig. 2 displays a schematic block diagram of the player shown in Fig. 1,
Figs. 3 to 7 exhibit examples of OSTA sorting tables,
Figs. 8 and 9 show input and output tables for OSTA sorting tables,
Fig. 10 displays an attribute table as used by the present invention,
Fig. 11 illustrates the creation of a sorting table according to the present invention, and
Fig. 12 shows an output table corresponding to the output table of Fig. 11 b) and the resulting sorting table corresponding to Fig. 11 d) but utilizing attribute indices.

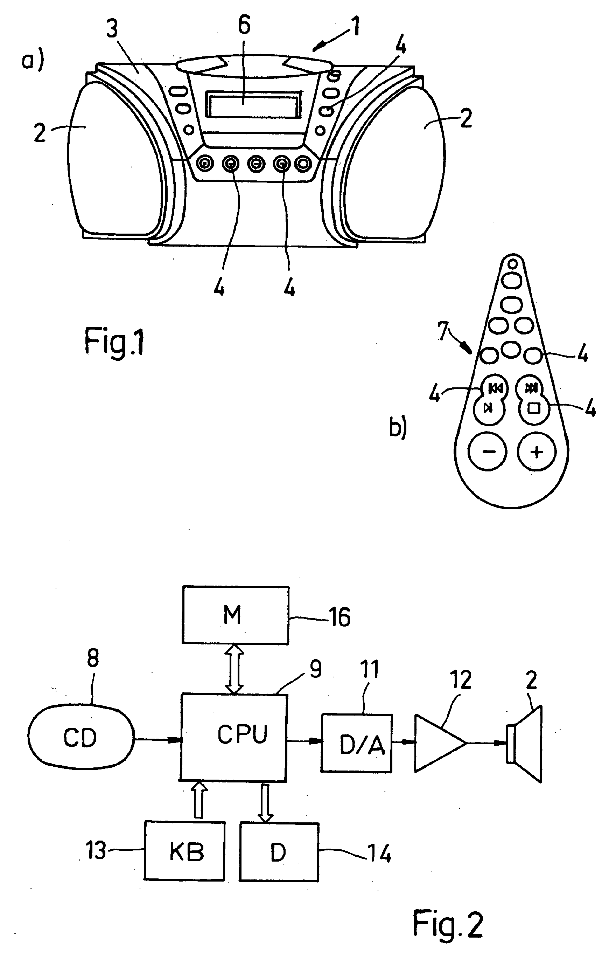

In Fig. 1 a portable MP3 player 1 is shown. The player 1 comprises loudspeakers 2 for sound reproduction integrated in a housing 3. The audio signals are reproduced from a disk not shown on which MP3 music files are stored. In the present embodiment the disk contains e.g. 150 music files. The disk is operated in the disk drive of the player 1. The functions of the player 1 are controllable by means of control elements 4 which are accessible by a user on the front side of the housing of the player. The housing 3 also accommodates a display 6 to indicate the status of the player 1 as well as other information for the user.

The player 1 is also controllable via an associated remote control 7 provided with control elements 4 corresponding to those which are arranged on the front side of the housing 3. It is noted that the plurality of control elements 4 may be replaced by a single multi-function input element.

Fig. 2 illustrates a schematic block diagram of the player 1 shown in Fig. 1. A disk unit 8 labeled with CD reads coded music data from a disk, which may be a CD or another type of disk. In another embodiment the disk unit 8 may be replaced by a flash memory means. The disk unit 8 outputs the music data to a central processing unit 9 (CPU) comprising a decoder to generate a decoded digital music data stream, which is converted into an analogue sound signal in a digital to analogue converter 11. A power amplifier 12 amplifies the analogue sound signal to drive the loudspeaker 2 for sound reproduction. A user through a keyboard 13 controls the operation of the player 1. The keyboard 13 in Fig. 2 represents the control elements 4 arranged on the player 1 or the remote control 7 as shown in Fig. 1. A display 14 indicates the operational status of the player 1 and other types of user information. In particular, the display 14 represents play lists and other types of sorting tables associated with the music files stored on the disk being loaded in the disk unit 8. A memory 16 contains data required to generate the different kinds of tables. The data are written into and read from the memory 16 by the CPU 9. The way in which the sorting tables are generated is described in the following.

In a first step the creation of known OSTA sorting tables is described.

The OSTA information helps the user to find particular songs in an easy and logical manner. The design of the user interface is easy to understand and supports simple navigation.

The main feature supported by the user-interface is
- Songs Sorting by OSTA attributes (Artist, Song Title/Name, Genre, Album, ..., etc);
- Traditional Folder /File Structure.

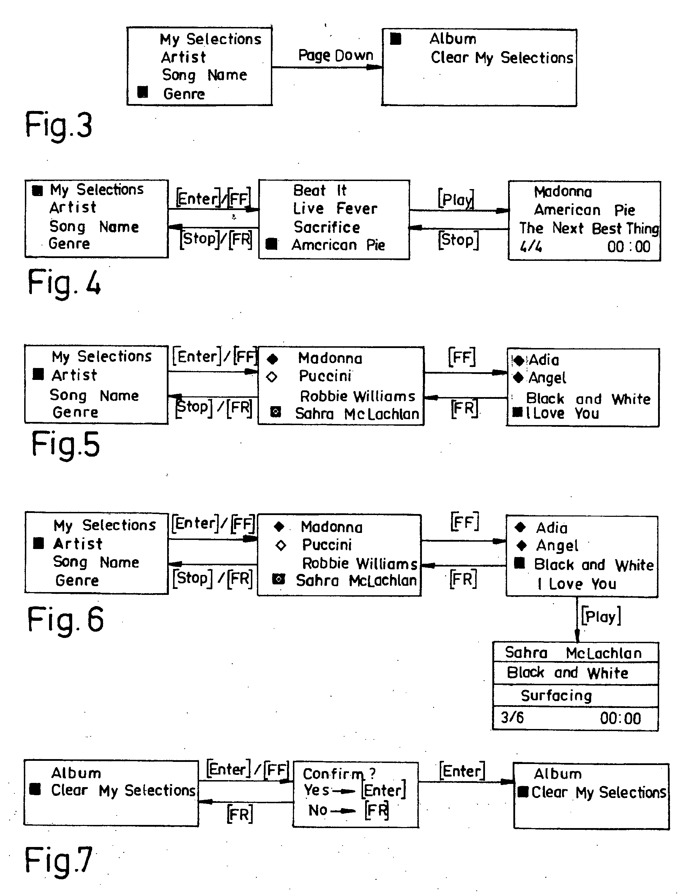

Once a disk with OSTA information is detected, an OSTA main menu as shown in Fig. 3 is displayed on the LCD screen 6 (Fig. 1). If a disk has no OSTA structure, otherwise, a traditional Folder/File structure is displayed which is not shown in the figures.

For a disk with OSTA structure, there is an option for switching between OSTA and traditional Folder/File structures providing additional flexibility for the user. Several menu functions are accessible by the user. This mode switching function can be selected in mode menu.

The first possibility is to compile a list called "My Selections" containing the songs selected by the user. The contents of the "My Selections" list can be displayed by moving a pointer in the display 6 to the "My selections" item in the main menu and then pressing an appropriate control element e.g. an [Enter] or fast forward [FF] button. The reproduction of the songs in the list can be started by pressing e.g. the [Play] button. The reproduction of the songs can be terminated by pressing the [STOP] button, which also triggers the display of the song list. To leave the "My Selections" list the user presses the [STOP] button again or the fast reverse [FR] button. The navigation through the different kinds of menus is illustrated in Fig. 4. To view content of "My Selections" list by moving pointer to "My Selections" item in the main menu and then pressing [Enter] or [FF] button. The songs in the list can be started to play by [Play] button. This can be summarized in Fig. 4.

Under an OSTA structure, songs can be searched and selected by OSTA attributes. The OSTA attributes supported include (i) artist name, (ii) song title/name, (iii) genre, and (iv) album.

In the main menu, one of the above attributes can be selected. Once the attribute is selected, a list of songs related to selected attribute is shown on the LCD screen. There are some marks for partial and completed selection of one particular attribute category.

Fig. 5 visualizes an example of using artist name selection. There are four artists in the menu and three ("Madonna", "Puccini" & "Sarah McLachlan") of them are selected as indicated by the symbols in front of the artists' names. All of the songs by "Madonna" are selected. Some songs by "Puccini" & "Sarah McLachlan" are selected. The current active line is on the song "I Love You" by "Sarah McLachlan".

All selected songs are stored into the "My Selections" list for playback. The "My Selections" list can be accessed and viewed in the main menu.

In the artist name menu, a certain artist is marked or selected by [Enter] key. All of the songs by that artist will be selected. By pressing [Enter] key again, that artist (including all the songs by that artist) is unmarked or unselected. It is noted that if a song is unmarked or unselected in the song listing, the marking of that artist in the artist name menu will be changed into partially selected mark.

The system will be returned to the main menu by [Stop] key. However, if the system is in the playback mode, the [Stop] key will be used for stopping playback only.

The ways to select other attributes (including Song Name, Genre, and Album) are similar. The only difference is that a different attribute category has to be selected.

Generally, the information of playback screen as it is shown on the right side in Fig. 4 contains (i) artist name, (ii) song title/filename, (iii) album, (iv) total number of songs, and (v) elapsed time.

There are two kinds of playback under OSTA structure. The first one is to play songs in the "My Selections" list. The second one is that playback is started at anywhere (except in the "My Selections" list) by pressing [Play] key.

In the playback of "My Selections" list, the songs to be played are the songs selected from the attribute selection, as described above. Thus, the "My Selections" list must be accessed and entered in the main menu before playback.

If a play action is not initiated in the "My Selections" list, the system will start to play at the current position and don't follow the sequence of the selected songs in the "My Selections" list.

As shown in Fig. 6, the play action is started in the artist name menu. Since the active line lies on the "Sarah McLachlan", all the songs of him are played from first his song. It is noted that the songs of "Madonna" and "Puccini" are not played although they are selected previously.

In example 2, the play action is started at current song list. Now, the active line is on the song name "Black and White". So, this song will be played and then next song of this artist "Sarah McLachlan" will be played.

A single song can be removed in the "My Selections" list. The system also allows to remove all the songs in the "My Selections" list. In the OSTA main menu, there is a function of clearing all songs in the "My Selections" list as shown in Fig. 7.

It is noted that there is a confirmation message after the function of "Clear My Selections" is selected from the OSTA main menu. All the songs in the "My Selections" list will be deleted or removed after the user confirms the deletion. If the user doesn't confirm the deletion, the OSTA main menu will return on the LCD screen 6.

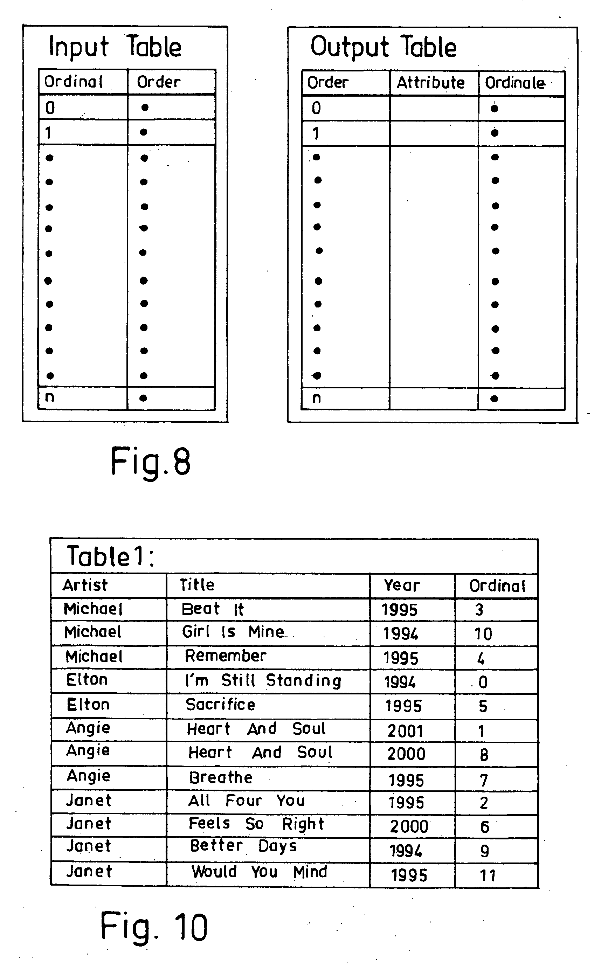

Each sorting table consists in fact of two tables as shown in Fig. 8. The "Input Table" is a look-up table for finding the sorted order of the entry for the given ordinal numbers. The "Output Table" is a look-up table for finding the actual attribute related to an entry.

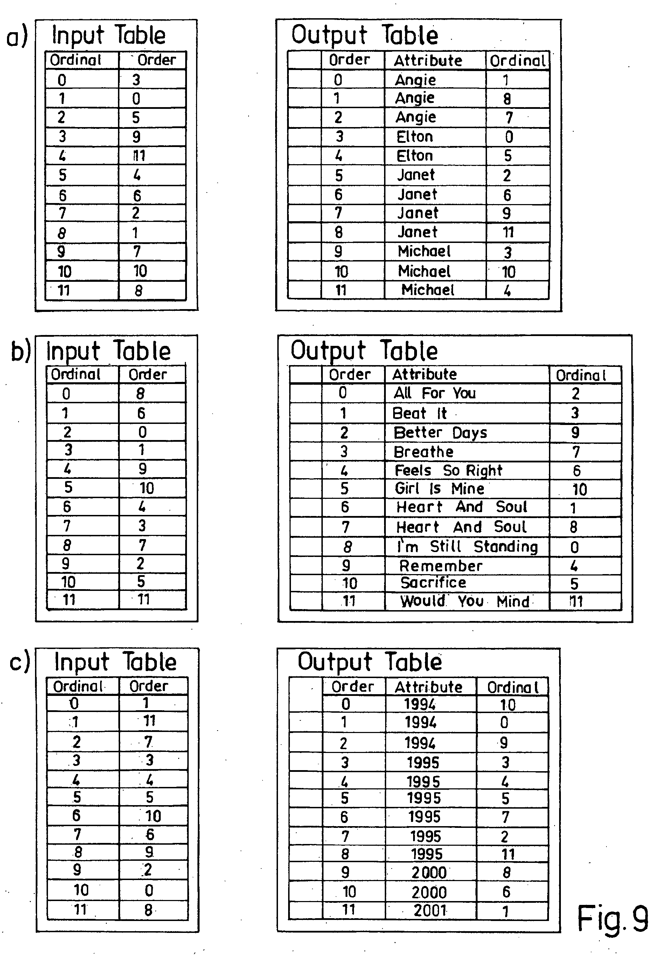

Figs. 9a to 9c illustrate three different types of output tables arranged according to different attributes. Fig. 9a shows an output table displaying the corresponding artist of a title, Fig. 9b the title of the songs and Fig. 9c the year.

In the tables the columns are labeled with the terms "Ordinal", "Order", and "Attribute". "Ordinal" defines a unique identification number for each song title on the disk. It is similar to the ordinal number defined in the MultiAudio (MA) of OSTA. It provides a reference for the location of the file on the disk. During the selection process, it is used as a token for passing through each table. Therefore, it is present in both tables. "Order " describes the order of the entry in the table. It does not have to be stored explicitly, but can be calculated as an offset. "Attribute" gives the actual attribute for the entry (e.g. title of a song). These attributes are sorted in an ascending order.

During user navigation, the device will perform three operations, *mark, scan* and *select.* When a set of ordinal numbers is input into the sorting table, the device will use the input table to mark the entries in the output table. It will then scan the output table for marked attributes, in order to construct the selections to be displayed. For entries that have different attributes, they are listed individually in the menu; otherwise they are collapsed into one item, with a "+" sign at the front of the attribute shown. After the user selects one of the items, the selected ordinal number is used as an input to the next sorting table.

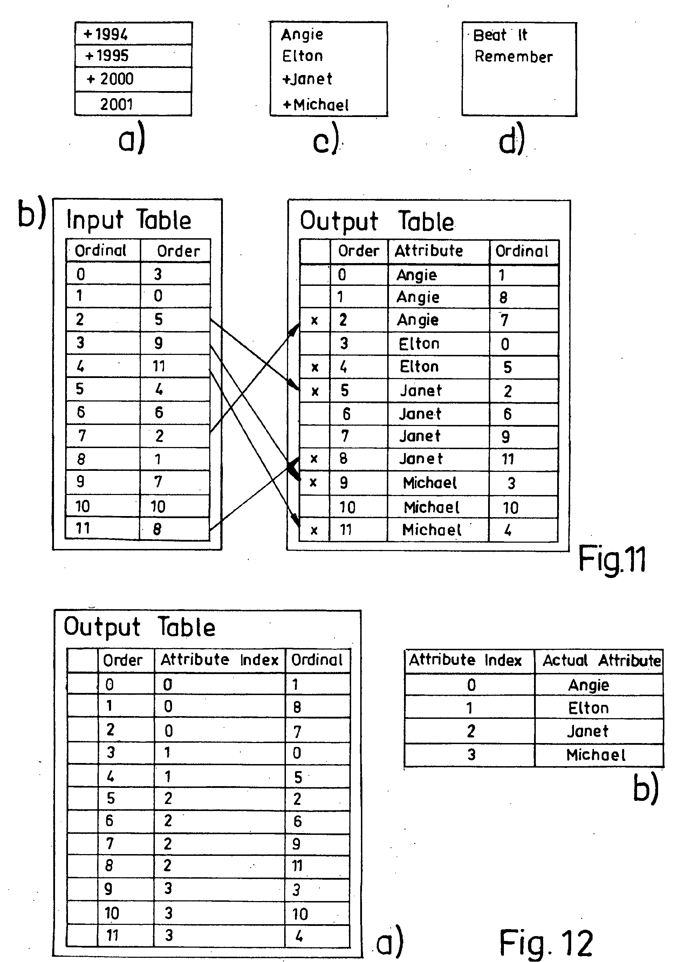

Fig. 10 displays an example to illustrate the operation of going through these sorting tables. As can be seen from Table 1 in Fig. 9 each item in the collection has three attributes namely "Artist", "Title", and "Year". There are four user operated navigation keys "UP", "DOWN", "FORWARD" and "BACK", which can be arranged on a remote control or on the playback device itself.

In the following the compilation of a sorting table according to the sequence "Year>Artist>Title" is described by way of an example.

For the first attribute, the whole sorting table output table will be marked. The input table does not provide any function in this particular case. All entries are therefore scanned in order to construct the user selection menu. The screen displays the table shown in Fig. 11a. The symbol "+" means in this case that there are more than one item with that attribute.

Supposing that the user selects "1995", the device will scan through the "Year" sorting table again, and determine the items with this attribute. The corresponding ordinal numbers are 3, 4, 5, 7, 2, and 11.

The next sorting attribute is "Artist". The device takes the ordinal numbers from the previous step, and uses them to mark entries in the "Artist" sorting table output table. The input table assists this marking process. For example, from the input table, ordinal number 3 is order "9", and the corresponding item in the output table is marked. The marking process is visualized in Fig. 11b).

After all the marking is done, the device scans from the beginning of the output table shown on the right side in Fig. 11b) and all attributes to be displayed. The screen subsequently shows as illustrated in Fig. 11c). If "Michael" is selected, the device will go back to the "Artist" output table, and find all the ordinal numbers with attribute "Michael" (3 and 4 in this case).

Similar operations are performed to the "Title" sorting table. The finally indicated display is illustrated in Fig. lid).

The "BACK" key can be used to go up one level of the selection. Markings for the current sorting table output table are cleared. Then the sorting table output table involved in the last display is scanned to generate the display screen under the assumption that markings for the previous sorting table are preserved.

The OSTA MultiAudio (MA) framework does not provide a straightforward way of incorporating the sorting table information. Although it is possible to "hide" the tables as play lists, or within the Extra Data area, this is not desirable. Using play list structures will inevitably cause non-Thomson devices to recognize these as valid play lists and present them to the users. The use of Extra Data area, on the other hand, are unrestrictive, and can potentially lead to interference with other devices.

It therefore makes more sense to put the sorting table information in separate file(s). Non-Thomson devices, thus minimizing compatibility issues, will not use this information. Our device will of cause support media that don't have this sorting table information; the available features might be reduced. For example, multi-level sorting might not be available, if there is not enough memory on the device.

Note that the sorting tables are not meant to replace the OSTA file; rather, they are supplements. Sorting tables relies on the MultiAudio (MA) to get the actual path information for individual tracks.

It is possible to generate the sorting tables from OSTA data during runtime. Storing the tables on the media, however, will definitely shorten the startup time. In fact, some devices might not even have enough resources to perform the required parsing and sorting. In this case the tables will be created by an Internet service, which is used to create the CD. When new tracks are added to a medium, new OSTA MultiAudio (MA) and sorting tables are generated.

In case a user would like to sort the contents of a medium in a particular sequence, e.g. Artist/Year/Album/Track. This additional information can also be stored on the medium as "Preferred Sorting Sequence" in the OSTA MultiAudio (MA) or together with the sorting tables.

For media with smaller size, flash-based system for example, smaller number of attributes (e.g. four) can be stored, thus minimizing the storage requirements.

Even with the "Mark, Scan and Select" scheme described above, the *Scan* step still involves some string comparisons. It is possible to eliminate these steps by putting in yet another table to eliminate duplicated attribute entries. Fig. 12 illustrates this.

With this method, the device does not need to compare strings anymore, although there will be one more level of look-up involved. It is save to assume that indexing is more efficient than comparing strings. Therefore, the device does not need to be as powerful if this scheme is adopted.

This approach is, of cause, only useful for string-type attributes.

A scheme for enabling multi-sorting order for devices with limited resources is proposed. This approach takes into considerations the memory requirement of the storage media, and processing power. Moreover, the resource requirements are scalable for different system constraints. During navigation, the device only need to perform indexing operation, thus reducing requirements on processing power. It is therefore suitable for system with minimal resources. Once the selections are made, the device will get the full information of the tracks from the OSTA MultiAudio (MA).

The invention method and the apparatus are described as exemplary embodiments in connection with audio data, in particular MP3 coded audio data. However, the invention is not limited to audio data files but can be applied to many type of data files stored on a storage medium. Similarly, the invention is described in connection with optical disks as storage medium. But it is also applicable to any other type of mass storage medium as hard disks or flash memory devices.

## Claims

1. Method for retrieving data files stored on a storage medium, having a plurality of associated attributes and an address
wherein the attributes and the address of all stored data files are listed in an input table being stored on the storage medium
wherein the method comprises the following steps:
a) selecting a first attribute among the plurality of associated attributes
b) generating a first output table containing only those entries of the input table corresponding to the selected first attribute
c) selecting a second attribute among the plurality of the associated attributes, the second attribute being different from the first attribute
d) generating a second output table containing only those entries of the first output table corresponding to the selected second attribute.

2. Method according to claim 1, **characterized by** iterating steps e) and d) for another attribute to generate another output table in a corresponding manner.

3. Method according to claim 1, **characterized by** iterating steps c) and d) for at least another attribute to generate at least another output table until all attributes associated to the data files have been selected.

4. Method according to one of the preceding claims **characterized by** the step of at least partially displaying an output table after to its generation.

5. Apparatus for sound reproduction comprising a memory, in which files of digital audio data are stored, a decoder for converting the stored audio data into analog sound signals, and circuitry for driving a loudspeaker,
wherein the memory contains data representing attributes of the stored audio files
**characterized by**
a processor for selecting a user determined attribute of the audio files and for creating a table of audio files corresponding to the attribute selection, and by a display for displaying the table.

6. Apparatus according to claim 5, **characterized in that** the memory comprises a disk drive.

7. Apparatus according to claim 5, **characterized in that** the memory comprises a solid state memory.

8. Apparatus according to claim 5, **characterized in that** a user operated input element to select the user determined attribute.

9. Apparatus according to claim 8, **characterized in that** the apparatus comprises a remote control equipped with the input element.

10. Apparatus according to claim 8 or 9, **characterized in that** the input element comprises a plurality of keys.
